Europäisches Patentamt

European Patent Office

Office européen des brevets

Veröffentlichungsnummer: **0 361 190**

**A1**

# EUROPÄISCHE PATENTANMELDUNG

Anmeldenummer: 89116777.7

Anmeldetag: 11.09.89

Int. Cl.⁵ **G01R 33/34 , G01R 33/36**

Priorität: 23.09.88 DE 3832473

Veröffentlichungstag der Anmeldung:
04.04.90 Patentblatt 90/14

Benannte Vertragsstaaten:
**DE GB**

Anmelder: **Siemens Aktiengesellschaft**
**Wittelsbacherplatz 2**
**D-8000 München 2(DE)**

Erfinder: **Ingwersen, Hartwig, Dr.**
**Zum Tennenbach 23**
**D-8525 Uttenreuth(DE)**

Oberflächenspulenanordnung für Untersuchungen mit Hilfe der kernnmagnetischen Resonanz.

Eine oberflächenspulenanordnung soll so aufgebaut werden. daß sie von homogenen Anregefeldern für die kernmagnetische Resonanz entkoppelt ist. Außerdem soll sie unempfindlich gegen Verstimmungen durch das Untersuchungsobjekt und äußere Störstrahlungen sein.

Die Oberflächenspulenanordnung besteht aus zwei geometrisch antiparallel angeordneten, identisch aufgebauten Oberflächenspulen, die so miteinander verbunden sind, daß hochfrequente Magnetfelder, die beide Spulen durchsetzen, keinen resultierenden Strom erzeugen. Dabei ist jede Oberflächenspule (1,2) durch ein zu einer Schleife geformtes Koaxialleiterstück gebildet, dessen Mantelabschirmung (1a,2a) an einer Stelle (1b,2b) eine Unterbrechung aufweist. An einem Ende (1c,2c) jedes Koaxialleiterstückes sind sowohl der Innenleiter (1d,2d) als auch die Mantelabschirmung (1a,2a) mit der Mantelabschirmung (1a,2a) des anderen Endes des Koaxialleiterstückes elektrisch verbunden.

Oberflächenspulen für Kernspin-Tomographen

FIG 2

EP 0 361 190 A1

## Oberflächenspulenanordnung für Untersuchungen mit Hilfe der kernmagnetischen Resonanz

Die Erfindung betrifft eine Oberflächenspulenanordnung für die Untersuchung eines Objektes mit Hilfe der kernmagnetischen Resonanz mit zwei geometrisch antiparallel angeordneten, identisch aufgebauten Oberflächenspulen, die elektrisch so miteinander verbunden sind, daß hochfrequente Magnetfelder, die beide Oberflächenspulen gleichmäßig durchsetzen, keinen resultierenden Strom erzeugen.

Eine derartige Anordnung ist beispielsweise bekannt aus der Zeitschrift "Radiology", 1986, 160, Seiten 695-699. Bei Verwendung von Oberflächenspulen zum Empfang von kernmagnetischen Signalen und Ganzkörperantennen zum Anregen von kernmagnetischen Signalen besteht stets das Problem, daß die Oberflächenspule von der gesendeten Hochfrequenzstrahlung entkoppelt werden muß. Ansonsten würde der in der Oberflächenspule induzierte Strom ein Hochfrequenzfeld hervorrufen, das dem Anregefeld überlagert wird. Dies würde zu Störungen bei der kernmagnetischen Bildgebung wie auch bei der Spektroskopie führen. Durch eine in Resonanz befindliche Oberflächenspule könnten so außerdem örtliche, auch auf den Patienten einwirkende Überhöhungen des Hochfrequenzfeldes erzeugt werden. Schließlich könnten durch in der Oberflächenspule entstehende Überspannungen Schäden im Empfangssystem verursacht werden.

Bei linear polarisierten Hochfrequenzfeldern kann dieses Problem dadurch umgangen werden, daß die Oberflächenspule parallel zum Anregefeld ausgerichtet wird. Dies bringt jedoch eine Reihe von betrieblichen Einschränkungen mit sich. Bei zirkularpolarisierten Anregefeldern kann das Problem auf diese Weise überhaupt nicht gelöst werden.

Zur Lösung dieses Problems sind in dem genannten Artikel in "Radiology" zwei schleifenförmige, mit einem Spalt versehene Resonatoren mit identischer Fläche vorgesehen, die räumlich zueinander parallel angeordnet sind. Die beiden Resonatoren werden an den Spalten elektrisch über Kreuz miteinander verbunden.

Daß diese Spulenanordnung unempfindlich gegen Einstrahlung durch ein homogenes Anregefeld ist, im Empfangsfall jedoch empfindlicher auf die vom Untersuchungsobjekt ausgehende Hochfrequenzstrahlung ist, kann am einfachsten durch folgende hochfrequenztechnische Überlegungen erläutert werden:

Die beiden geometrisch antiparallel angeordneten Oberflächenspulen stellen mit ihrer elektrischen Beschaltung zwei Resonanzkreise mit gleicher Resonanzfrequenz dar. Durch die enge geometrische Nähe sowie die schaltungsmäßige Verbindung ergibt sich ein System von zwei stark gekoppelten Resonanzkreisen, das nun zwei separate Resonanzfrequenzen aufweist, bei denen die Ströme gleichsinnig bzw. gegensinnig fließen. Die Einstellung erfolgt nun so, daß die Resonanzfrequenz mit gegensinnigen Strömen gleich der Betriebsfrequenz der kernmagnetischen Apparatur ist. Damit ist diese Spulenanordnung empfindlich für den Empfang von kernmagnetischen HF-Signalen aus einer vom Untersuchungsobjekt ausgehenden inhomogenen HF-Feldverteilung, nicht jedoch für das homogene Anregefeld, das gleichsinnige Ströme anregen würde, deren Resonanzfrequenz von der Betriebsfrequenz genügend verschieden ist. Die so aufgebaute Oberflächenspulenanordnung ist somit von dem homogenen Anregungsfeld entkoppelt und zwar unabhängig von der Lage der Oberflächenspulenanordnung in Relation zur Feldrichtung. Dies gilt auch für zirkularpolarisierte Anregefelder.

Die Abstimmung sowie die Leitungsanpassung von Oberflächenspulenanordnungen hängt im allgemeinen sehr stark von der Belastung durch das jeweilige Untersuchungsobjekt ab. Daher ist im allgemeinen ein Neuabgleich bei jedem Wechsel des Objektes unumgänglich. Dies führt zu einer Verlängerung der Untersuchungszeiten sowie darüber hinaus zu einer gewissen Unsicherheit bzw. Schwankung der Untersuchungsergebnisse, die hauptsächlich durch Bewegungen des Untersuchungsobjektes während der Untersuchung hervorgerufen wird.

Außerdem besteht eine Empfindlichkeit gegen Einstrahlung von elektrischer Störstrahlung von außen.

Eine wenig verstimmbare und störstrahlungssichere Oberflächenspule wurde in der europäischen Patentanmeldung 0 222 982 vorgeschlagen. Dabei wird die Oberflächenspule durch ein zu einer Schleife geformtes Koaxialleiterstück gebildet, dessen Mantelabschirmung an einer Stelle eine Unterbrechung aufweist, wobei an einem Ende des Koaxialleiterstückes sowohl der Innenleiter als auch die Mantelabschirmung mit der Mantelabschirmung des anderen Endes des Koaxialleiterstückes elektrisch verbunden sind. Aufgrund der Wirkung der Mantelabschirmung ist diese Oberflächenspule gegen kapazitive Verstimmung durch äußere Einflüsse sowie gegen äußere elektrische Störstrahlungen weitgehend unempfindlich. Es bleibt allerdings das Problem der Entkoppelung gegen das Anregefeld.

Aufgabe der Erfindung ist es daher, eine Oberflächenspulenanordnung zu schaffen, die gegen lastabhängige, kapazitive Verstimmungen weitgehend unempfindlich ist und die von einem homogenen Anregefeld entkoppelt ist.

Diese Aufgabe wird erfindungsgemäß dadurch gelöst, daß jede Oberflächenspule durch ein zu einer Schleife geformtes Koaxialleiterstück gebildet ist, dessen Mantelabschirmung an einer Stelle eine Unterbrechung aufweist, wobei an einem Ende des Koaxialleiterstückes sowohl der Innenleiter als auch die Mantelabschirmung mit der Mantelabschirmung des anderen Endes des Koaxialleiterstückes elektrisch verbunden sind und wobei die Schleifen der beiden Oberflächenspulen entgegengesetzten Windungssinn haben.

Bei dieser Anordnung erzeugen homogene HF-Anregungsfelder keinen resultierenden Strom, so daß die Anordnung bezüglich des Anregungsfeldes beliebig orientierbar ist und auch in einem zirkular polarisierten Anregungsfeld verwendet werden kann. Durch die Unterdrückung elektrischer Feldkomponenten durch die Mantelabschirmung werden elektrische Feldkomponenten weitgehend unterdrückt, so daß die lastabhängige Verstimmung gering bleibt. Somit ist keine Untersuchungsobjekt-abhängige HF-Anpassung erforderlich. Aufgrund der Entkoppelung kann im Bereich der Oberflächenspule keine Feldüberhöhung erfolgen, so daß eine lokal erhöhte Belastung des Untersuchungsobjektes mit Hochfrequenzstrahlen oder eine Überspannung in der Empfangsanlage ausgeschlossen sind. Durch die Entkoppelung erhält man auch eine homogenere Bildintensitätsverteilung als mit einer einzelnen Oberflächenspule. Verglichen mit den aus der eingangs genannten Literaturstelle "Radiology" bekannten schleifenförmigen Resonatoren mit Spalt ist ein wesentlich flacherer Aufbau möglich, da die verhältnismäßig hohen Bänder durch relativ dünne Leitungen ersetzt werden können.

In einer vorteilhaften Ausführungsform sind die Innenleiter und die Mantelabschirmungen beider Oberflächenspulen jeweils miteinander verbunden, wobei die Innenleiter beider Oberflächenspulen über einen ersten abstimmbaren Kondensator an den Innenleiter einer koaxialen Einspeiseleitung angeschlossen sind, wobei die Mantelabschirmungen beider Oberflächenspulen an die Mantelabschirmung der Einspeiseleitung angeschlossen ist und wobei zwischen den Innenleitern der Oberflächenspulen und deren Mantelabschirmungen ein zweiter abstimmbarer Kondensator angeordnet ist. Damit kann die Oberflächenspulenanordnung an den Wellenwiderstand der Zuleitung angepaßt werden.

Möglichkeiten, zwei erfindungsgemäße Oberflächenspulenanordnungen zusammenzuschalten und damit eine Anpassung des Empfindlichkeitsbereiches an den gewünschten Untersuchungsbereich zu erreichen, sind in den Unteransprüchen 5 bis 9 angegeben.

Die Erfindung wird nachfolgend anhand von Ausführungsbeispielen nach den FIG 1 bis 9 näher erläutert. Dabei zeigt:

FIG 1 den prinzipiellen Aufbau eines Kernspin Resonanzgerätes.

FIG 2 eine einzelne Oberflächenspule, wie sie in der älteren europäischen Patentanmeldung 86111082.3 vorgeschlagen wurde.

FIG 3 ein erstes Ausführungsbeispiel der Erfindung,

FIG 4 eine zugehörige Anpaßvorrichtung,

FIG 5-8 weitere vorteilhafte Ausführungsbeispiele und

FIG 9 eine weitere Anpaßvorrichtung.

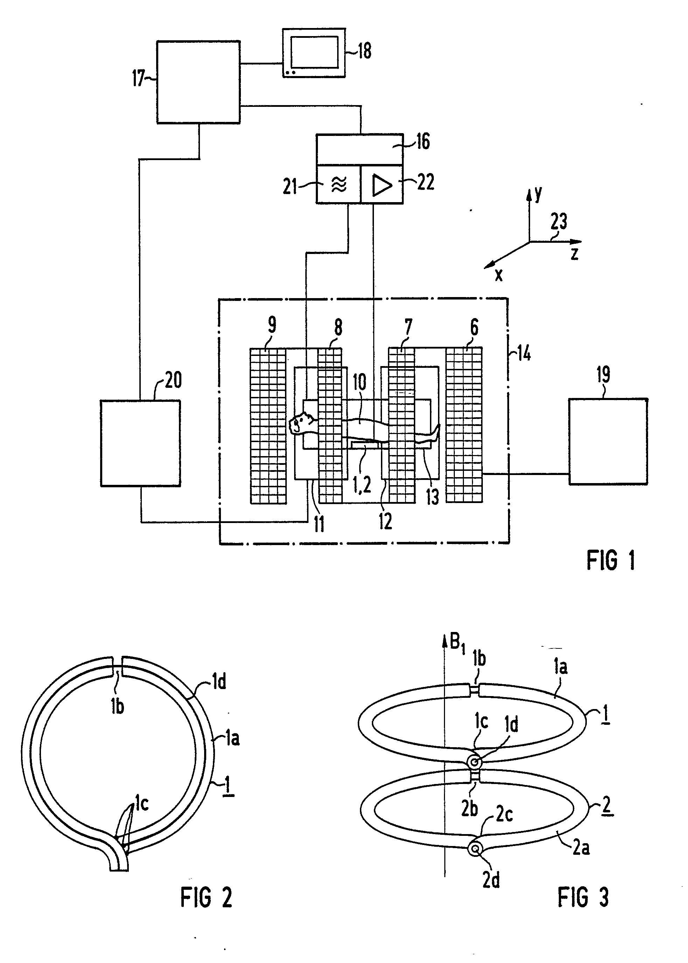

FIG 1 zeigt schematisch den prinzipiellen Aufbau eines Kernspin-Resonanzgerätes, in diesem Fall eines Kernspin-Tomographiegerätes für die Erstellung von Schnittbildern eines Untersuchungsobjektes. Mit 6 und 7 sowie 8 und 9 sind Spulen bezeichnet, die ein magnetisches Grundfeld $B_0$ erzeugen, in welchem sich bei Anwendung zur medizinischen Diagnostik der zu untersuchende Körper 10 eines Patienten als Untersuchungsobjekt befindet. Diesem sind außerdem Gradientenspulen zugeordnet, die zur Erzeugung unabhängiger, zueinander senkrechter Magnetfeldgradienten der Richtungen x,y und z gemäß dem Koordinatenkreuz 23 vorgesehen sind. In der FIG 1 sind der Übersichtlichkeit halber nur die Gradientenspulen 11 und 12 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallel zum Körper 10 und oberhalb sowie unterhalb von ihm, die für das z-Gradientenfeld quer zu seiner Längsachse am Fuß- und am Kopfende. Die Anordnung enthält außerdem noch einen zur Erzeugung der Kernresonanzsignale dienenden Körper-Resonator 13 zur Erzeugung eines Anregungsfeldes sowie eine zur Aufnahme der Kernresonanzsignale dienende Oberflächenspulenanordnung 1,2.

Die von einer strichpunktierten Linie 14 umgrenzten Spulen 1,2,6,7,8,9,11,12 und 13 stellen das eigentliche Untersuchungsinstrument dar. Es wird von einer elektrischen Anordnung aus betrieben, die ein Netzgerät 19 zum Betrieb der Spulen 6 bis 9 sowie eine Gradientenstromversorgung 20, an welcher die Gradientenspulen 11 und 12 sowie die weiteren Gradientenspulen liegen, umfaßt. Ein von einem Prozeßrechner 17 gesteuerter Hochfrequenzsender 21 ist mit dem Körper-Resonator 13 verbunden. Die Oberflächenspulenanordnung 1,2 ist über einen Signalverstärker 22 ebenfalls an den Prozeßrechner 17 gekoppelt, an dem zur Ausgabe einer Abbildung ein Bildschirmgerät 18 angeschlossen ist. Die Komponenten 21 und 22 bilden eine Hochfrequenzeinrichtung 16 zur Signalerzeugung und -aufnahme.

Wie in FIG 2 dargestellt, besteht die einzelne Oberflächenspule 1 aus einem zu einer Schleife geformten Koaxialleiterstück, wobei am Ende 1c dieser Schleife sowohl der Innenleiter 1d als auch die Mantelabschirmung 1a mit der Mantelabschirmung 1a am Anfangspunkt 1c der Schleife elektrisch verbunden sind. An einem dem Anfangspunkt 1c der Schleife gegenüberliegenden Punkt 1b weist die Mantelabschirmung 1a eine Unterbrechung auf

Diese Anordnung wirkt als Rahmenantenne, die zur Ausbildung einer gewissen Sende- und Empfangscharakteristik des magnetischen Wechselfeldes sowie zur Vermeidung von Störungen mit einer an bevorzugter Stelle unterbrochenen koaxialen Abschirmung versehen ist. Die elektrische Unterbrechung der Abschirmung kann an jeder beliebigen Stelle der Schleife erfolgen, wobei jedoch eine symmetrische Anordnung mit der Lage der Unterbrechung gegenüber dem Einspeisungspunkt der Schleife die Sende- und Empfangscharakteristik verbessert. Die Breite der Unterbrechung 1b der Mantelabschirmung sollte etwa dem Abstand des Innenleiters 1d zur Mantelabschirmung 1a entsprechen Durch die mit der Mantelleitung 1a gegebene Abschirmung werden kapazitive Einflüsse des Untersuchungsobjektes auf die Oberflächenspule der Antenne vermieden, so daß deren Resonanzfrequenz vom untersuchungsobjekt weitgehend unabhängig wird. Ferner bleibt die Oberflächenspule auch bei ungenügender Raumabschirmung von äußeren elektrischen Störstrahlungen unbeeinflußt.

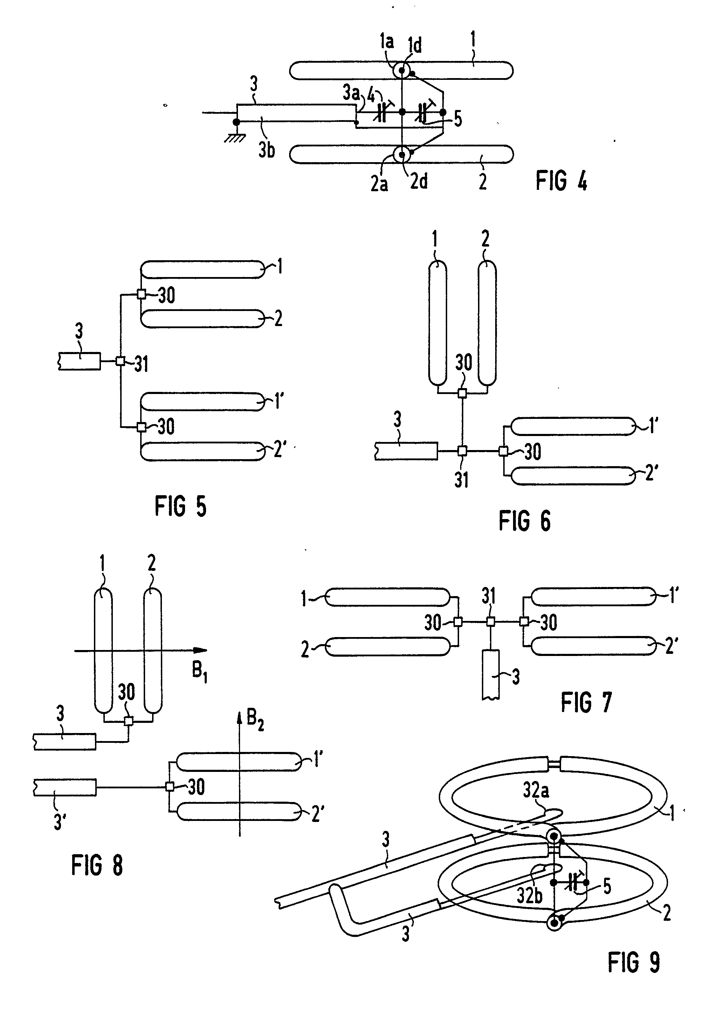

FIG 3 zeigt zwei gleichartige Oberflächenspulen 1 und 2 mit gleicher umschlossener Fläche gemäß FIG 2, die entsprechend der Erfindung zueinander geometrisch antiparallel angeordnet sind, d.h. es sind die beiden Oberflächenspulen 1,2 um 180° gegeneinander geklappt, so daß die entsprechenden Schleifen einen unterschiedlichen Windungssinn haben. Die beiden Oberflächenspulen 1,2 sind ausgangsseitig parallel geschaltet und mit einem variablen Kondensator 5 (FIG 4) zur Resonanz gebracht. Die Einstellung erfolgt so, daß bei der Betriebsfrequenz der kernmagnetischen Anlage gegensinnige resonante Ströme fließen, die Resonanzfrequenz mit gleichsinnigen Strömen jedoch genügend weit von dieser Betriebsfrequenz wegliegt. Ein die beiden Oberflächenspulen 1,2 gleichmäßig durchsetzendes Hochfrequenzfeld B1 induziert daher in der Anordnung keinen resultierenden Strom Da die Anregung der kernmagnetischen Resonanz üblicherweise mit Ganzkörper-Antennen mit homogenen Anregungsfeldern erfolgt, ist somit die dargestellte Oberflächenspulenanordnung vom Anregungsfeld entkoppelt, und zwar unabhängig von der Orientierung zum Anregungsfeld. Dies gilt auch für zirkularpolarisierte Anregungsfelder.

Die aufgrund der kernmagnetischen Resonanz vom Untersuchungsobjekt ausgehende Hochfrequenzfeldverteilung ist jedoch inhomogen. Dieses Feld durchsetzt die beiden Oberflächenspulen 1 und 2 daher nicht gleichmäßig, so daß ein resultierender Strom induziert wird und somit das Kernresonanzsignal mit der Oberflächenspulenanordnung erfaßt werden kann.

FIG 4 zeigt eine kapazitive Anpaßschaltung zur Anpassung des Wellenwiderstandes der Oberflächenspulenanordnung an den Wellenwiderstand einer Zuleitung 3. Dabei sind die Innenleiter 1d und 2d und die Mantelabschirmungen 1a und 2a jeweils miteinander verbunden. Der Innenleiter 3a einer Zuleitung 3 ist über einen abstimmbaren Kondensator 4 mit den beiden Innenleitern 1d und 2d und die Mantelabschirmung 3b der Zuleitung 3 mit den Mantelabschirmungen 1a und 2a verbunden. Ferner sind die beiden Innenleiter 1d und 2d über einen weiteren abstimmbaren Kondensator 5 mit den Mantelabschirmungen 1a und 2a verbunden. Durch Abstimmung der Kondensatoren 4 und 5 kann der Wellenwiderstand der Oberflächenspulenanordnung 1,2 an den Wellenwiderstand der Zuleitung 3 angepaßt werden.

Die FIG 5 bis 8 zeigen Kombinationen von Oberflächenspulenanordnungen, mit denen der Sensitivitätsbereich an den gewünschten Untersuchungsbereich angepaßt werden kann. Bei einer Anordnung nach FIG 5 sind zwei Oberflächenspulenanordnungen 1,2 und 1',2' in Form einer Helmholtz-Anordnung axial angeordnet. Die Anpassungen untereinander und an eine koaxiale Zuleitung 3 erfolgt über Anpaßnetzwerke 30, 31. Im Raum zwischen den beiden Oberflächenspulenanordnungen 1,2 und 1',2' kann damit eine besonders homogene Empfindlichkeitszone erreicht werden. Bei einer Anordnung nach FIG 6 sind zwei Oberflächenspulenanordnungen 1,2 und 1',2' in einem Winkel, der im Ausführungsbeispiel 90° beträgt, angeordnet und über Anpaßnetzwerke 30,31 mit einer gemeinsamen Anschlußleitung 3 verbunden. Der Winkel zwischen den beiden Oberflächenspulenanordnungen 1, 2 und 1',2' kann beliebig gewählt werden.

Bei einer Anordnung nach FIG 7 sind zwei Oberflächenspulenanordnungen 1,2 und 1',2' in einer Ebene angeordnet und ebenfalls über Anpaßnetzwerke 30, 31 an eine gemeinsame Anschlußleitung 3 angeschlossen.

Bei einer Anordnung nach FIG 8 sind zwei Oberflächenspulenanordnungen 1,2 und 1',2' in einem rechten Winkel zueinander angeordnet. Beide Oberflächenspulenanordnungen 1,2 und 1',2' sind mit je einer getrennten Anschlußleitung 3,3' versehen. Durch Einfügung einer 90°-Phasenleitung oder eines anderen beliebigen, eine Phasenverschiebung von 90° erzeugenden Bauteiles in eine Anschlußleitung, kann in einem gewissen Volumen, in dem beide Feldkomponenten senkrecht aufeinander stehen, zirkular gesendet oder empfangen werden und bei geeigneter Umschaltung von + 90° auf - 90° auch zirkular gesendet und empfangen werden.

FIG 9 zeigt eine Möglichkeit zur induktiven Ankoppelung einer Oberflächenspulenanordnung 1,2 an eine Übertragungsleitung 3. Dabei wird der Innenleiter einer Anschlußleitung 3 zu einer Drahtschleife 32a gebogen und an die Mantelabschirmung der Anschlußleitung 3 zurückgeführt. Diese Drahtschleife 32a wird in der Nähe einer Oberflächenspule 1 angeordnet, so daß die Anschlußleitung 3 induktiv mit der Oberflächenspule 1 gekoppelt ist. Aus Symmetriegründen kann eine zweite Drahtschleife 32b vorgesehen sein, die mit der zweiten Oberflächenspule 2 induktiv gekoppelt ist. Die Innenleiter 1d,2d und die Mantelabschirmungen 1a,2a sind über einen abstimmbaren Kondensator 5 mit den Mantel abschirmungen 1a,2a verbunden. Mit dem abstimmbaren Kondensator 5 kann die Oberflächenspulenanordnung auf die gewünschte Resonanzfrequenz abgeglichen werden.

Eine weitere vorteilhafte Anwendung der erfindungsgemäßen Oberflächenspulenanordnung wird durch Anpaßschaltungen möglich, durch die die Oberflächenspulenanordnung gleichzeitig auf zwei verschiedene Resonanzfrequenzen eingestellt werden kann. Dabei können die beiden "natürlichen" Resonanzfrequenzen der Anordnung ausgenutzt werden. Damit kann z.B. mit der gleichen Anordnung ohne Wechsel der Oberflächenspule kurz hintereinander oder gleichzeitig Protonenbildgebung und Phosphorspektroskopie erfolgen. Eine Anpaßschaltung für zwei Betriebsfrequenzen ist beispielsweise aus der DE-OS 36 34 030 bekannt.

Über den reinen Empfangsbetrieb hinaus eignet sich die dargestellte Oberflächenspulenanordnung in allen Variationen auch zum Sendebetrieb. Entsprechende Sende-/Empfangsumschaltungen sind bei Kernspin-Tomographie-Anlagen üblicherweise vorhanden. Dies ist insbesondere bei MR-Spektroskopie dann wichtig, wenn neben dem homogenen Anregefeld Verfahren zur Anwendung kommen sollen, die auf der inhomogenen Anregung durch die Oberflächenspulenanordnung basieren.

## Ansprüche

1. Oberflächenspulenanordnung für die Untersuchung eines Objektes mit Hilfe der kernmagnetischen Resonanz mit zwei geometrisch antiparallel angeordneten, identisch aufgebauten Oberflächenspulen (1,2), die elektrisch so miteinander verbunden sind, daß hochfrequente Magnetfelder, die beide Oberflächenspulen (1,2) gleichmäßig durchsetzen, keinen resultierenden Strom induzieren.

**dadurch gekennzeichnet,**

daß jede Oberflächenspule (1,2) durch ein zu einer Schleife geformtes Koaxialleiterstück gebildet ist, dessen Mantelabschirmung (1a,2a) an einer Stelle (1b,2b) eine Unterbrechung aufweist, daß an einem Ende (1c,2c) des Koaxialleiterstückes sowohl der Innenleiter (1d,2d) als auch die Mantelabschirmung (1a,2a) mit der Mantelabschirmung (1a,2a) des anderen Endes des Koaxialleiterstückes elektrisch verbunden sind und daß die Schleifen der beiden Oberflächenspulen (1,2) entgegengesetzten Windungssinn haben.

2. Oberflächenspulenanordnung nach Anspruch 1,

**dadurch gekennzeichnet,**

daß die Innenleiter (1d,2d) und die Mantelabschirmungen (1a,2a) beider Oberflächenspulen (1,2) jeweils miteinander verbunden sind, daß die Innenleiter (1d,2d) beider Oberflächenspulen (1,2) über einen ersten abstimmbaren Kondensator (4) an den Innenleiter (3a) einer koaxialen Einspeiseleitung (3) angeschlossen sind, daß die Mantelabschirmungen (1a,2a) beider Oberflächenspulen (1,2) an die Mantelabschirmung (3b) der Einspeiseleitung (3) angeschlossen sind und daß zwischen den Innenleitern (1d,2d) der Oberflächenspulen (1,2) und deren Mantelabschirmungen (1a,2a) ein zweiter abstimmbarer Kondensator (5) angeordnet ist.

3. Oberflächenspulenanordnung nach Anspruch 1,

**dadurch gekennzeichnet,**

daß die Innenleiter (1d,2d) und die Mantelabschirmungen (1a,2a) beider Oberflächenspulen (1,2) jeweils miteinander verbunden sind, daß zwischen den Innenleitern (1d,2d) und den Mantelabschirmungen (1a,2a) ein abstimmbarer Kondensator (5) angeordnet ist und daß die Ein- und Auskoppelung von Signalen über eine in der Nähe einer ersten Oberflächenspule (1) angeordnete Drahtschleife (32a) erfolgt, die mit der Zuleitung (3) verbunden ist.

4. Oberflächenspulenanordnung nach Anspruch 3,

**dadurch gekennzeichnet,**

daß in der Nähe der zweiten Oberflächenspule (2) eine weitere Drahtschleife (32b) so angeordnet ist, daß eine symmetrische Auskoppelung an beide Oberflächenspulen (1,2) erfolgt.

5. Oberflächenspulenanordnung nach einem der Ansprüche 1 bis 4,

**dadurch gekennzeichnet,**

daß zwei Oberflächenspulenanordnungen (1,2;1',2') in einer Ebene vorgesehen sind, die durch Anpaßnetzwerke (30.31) untereinander und mit der Zuleitung (3) verbunden sind.

6. Oberflächenspulenanordnung nach einem der Ansprüche 1 bis 4,

dadurch gekennzeichnet,

daß zwei Oberflächenspulenanordnungen (1,2;1´,2´) axial zueinander vorgesehen sind. die durch Anpaßnetzwerke (30,31) untereinander und mit der Zuleitung (3) verbunden sind.

7. Oberflächenspulenanordnung nach einem der Ansprüche 1 bis 4, **dadurch gekennzeichnet,** daß zwei Oberflächenspulenanordnungen (1,2;1´,2´) vorgesehen sind. deren Flächen zueinander einen Winkel bilden und die durch Anpaßnetzwerke (30,31) untereinander und mit der Zuleitung (3) verbunden sind.

8. Oberflächenspulenanordnung nach einem der Ansprüche 1 bis 4,

**dadurch gekennzeichnet,**

daß zwei Oberflächenspulenanordnungen (1,2; 1´2´) in einem Winkel von 90° angeordnet sind, wobei die Oberflächenspulenanordnungen (1,2;1´,2´) jeweils mit einer eigenen Zuleitung (3) versehen sind.

9. Oberflächenspulenanordnung nach einem der Ansprüche 1 bis 8,

**dadurch gekennzeichnet,**

daß das Anpaßnetzwerk (30) für den gleichzeitigen Betrieb mit zwei Resonanzfrequenzen geeignet ist.

FIG 1

FIG 2

FIG 3

FIG 4

FIG 5

FIG 6

FIG 7

FIG 8

FIG 9

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | MAGNETIC RESONANCE IN MEDICINE, Band 6, Nr. 3, März 1988, Seiten 253-264, Academic Press Inc., Duluth, MN, US; T.M. GRIST et al.: "Doubly tuned local coils for MRI and MRS at 1.5. T" * Seiten 253-258; Figuren 2B,4-6 * | 1,3,9 | G 01 R 33/34 G 01 R 33/36 |
| Y | EP-A-0 222 982 (SIEMENS AG) * Spalte 1, Zeile 28 - Spalte 2, Zeile 39; Spalte 3, Zeilen 20-34; Figuren 1,3-5 * | 1,2,6-8 | |
| Y | DE-A-3 608 473 (ELSCINT LTD) * Seite 1, Zeile 1 - Seite 4, Zeile 20; Seite 11, Zeile 24 - Seite 12, Zeile 3; Figuren 5,6 * | 1,9 | |
| A | US-A-4 373 163 (J. VANDEBULT) * Spalte 1, Zeile 59 - Spalte 2, Zeile 68; Spalte 3, Zeile 25 - Spalte 4, Zeile 7; Spalte 5, Zeilen 16-28; Figuren 1,2,5-7 * | 1 | |
| A | EP-A-0 249 298 (PHILIPS PATENTVERWALTUNG GmbH) * Spalte 1, Zeile 26 - Spalte 3, Zeile 6; Spalte 4, Zeile 53 - Spalte 6, Zeile 28; Figuren 1,2a,2b * | 1,2,5,9 | RECHERCHIERTE SACHGEBIETE (Int. Cl.5)<br><br>G 01 N G 01 R H 01 Q |
| A | EP-A-0 218 290 (N.V. PHILIPS' GLOEILAMPENFABRIEKEN) * Seite 4, Zeilen 3-22; Figur 2 * | 1 | |
| A,P | EP-A-0 290 315 (GENERAL ELECTRIC CGR S.A.) * Spalte 3, Zeile 6 - Spalte 4, Zeile 57; Figuren 2a-5 * | 1 | |

Der vorliegende Recherchenbericht wurde für alle Patentansprüche erstellt

| Recherchenort | Abschlußdatum der Recherche | Prüfer |
|---|---|---|
| DEN HAAG | 28-12-1989 | HORAK G.I. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)